Europäisches Patentamt

(19) European Patent Office

Office européen des brevets

(11) Publication number: **0 449 632 A2**

(12) **EUROPEAN PATENT APPLICATION**

(21) Application number: **91302748.8**

(22) Date of filing: **28.03.91**

(51) Int. Cl.⁵: **H04N 5/268**

(30) Priority: **28.03.90 JP 80302/90**

(43) Date of publication of application:
**02.10.91 Bulletin 91/40**

(84) Designated Contracting States:
**DE FR GB**

(71) Applicant: **SONY CORPORATION**
**7-35, Kitashinagawa 6-chome Shinagawa-ku**
**Tokyo (JP)**

(72) Inventor: **Shoda, Akihiko**
**c/o Sony Corporation 7-35 Kitashinagawa**
**6-chome**
**Shinagawa-ku Tokyo (JP)**
Inventor: **Usui, Yoshinobu**
**c/o Sony Corporation 7-35 Kitashinagawa**
**6-chome**
**Shinagawa-ku Tokyo (JP)**
Inventor: **Mizutani, Tomoji**
**c/o Sony Corporation 7-35 Kitashinagawa**
**6-chome**
**Shinagawa-ku Tokyo (JP)**

(74) Representative: **Nicholls, Michael John et al**
**J.A. Kemp & Co., 14, South Square, Gray's Inn**
**London WC1R 5EU (GB)**

(54) **Matrix switcher apparatus.**

㉗    This invention provides a matrix switcher apparatus adapted to arbitrarily distribute inputs of a plurality of channels to outputs of a plurality of channels, characterized in that the matrix switcher apparatus is permitted to have therein a cross point matrix adapted for connecting one matrix switcher unit to any other matrix switcher unit or units to carry out expansion of input/output, and that input and output terminals expandable up to a predetermined maximum number of channels can be provided in the matrix switcher apparatus. Further, this invention provides a matrix switcher apparatus comprising : a cross point matrix including input terminals of a plurality of channels, and output terminals of at least partial channels of the plurality of channels and channels expandable to any other unit or units ; and a cross point matrix including input terminals of partial channels and channels expandable to any other unit or units, and output terminals of partial channels of the apparatus, thereby making it possible to constitute the system on a compact scale or various scales, and to reduce the cost.

EP 0 449 632 A2

**FIG. 3(a)**

**FIG. 3(b)**

This invention relates to so called a matrix switcher apparatus (matrix routing switcher apparatus) adapted to arbitrarily distribute inputs of a plurality of channels, e.g., for video signals or audio signals, etc. to outputs of a plurality of channels to deliver the distributed outputs.

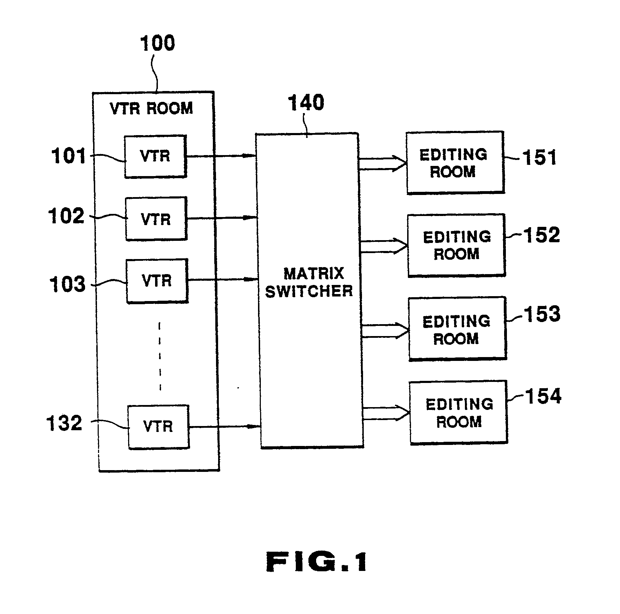

At the place where a plurality of equipments (e.g., video tape recorders (VTRs)) are dealt to carry out, e.g., editing work, such as, for example, in broadcasting stations or post productions, there may be used so called a matrix switcher apparatus (matrix routing switcher apparatus) for arbitrarily distributing inputs of a plurality of channels from these plurality of equipments (VTRs) to outputs of a plurality of channels (editing rooms, etc.). Namely, as shown in FIG. 1, in the case of transmitting signals (video signals) of respective channels from, e.g., 32 VTRs 101 to 132 within a VTR room 100, e.g., with these signals being distributed by 8 channels every four editing rooms 151 to 154, signals from respective VTRs are once transmitted to a matrix switcher apparatus 140. Then, these signals are distributed and transmitted to the respective editing rooms by the matrix switcher apparatus 140.

In such a matrix switcher apparatus, the matrix size required varies diversely in dependency upon the scale of the system using the matrix switcher apparatus. Namely, according as the number of VTRs or the number of editing rooms is increased, the matrix size of the matrix switcher apparatus becomes larger. The matrix size of the matrix switcher apparatus at this time is ordinarily expressed as the number of inputs (the number of input channels) x the number of outputs (the number of output channels). For example, when the matrix size is expressed as 16 x 16, a matrix switcher apparatus having the number of inputs of 16 channels and the number of outputs of 16 channels is provided. Further, e.g., when the matrix size is expressed as 32 x 32, a matrix switcher apparatus having the number of inputs of 32 channels and the number of outputs of 32 channels is provided. Switches are arranged on the cross points of 16 x 16 or 32 x 32, respectively. When any switch is selected, distribution of input channels is carried out.

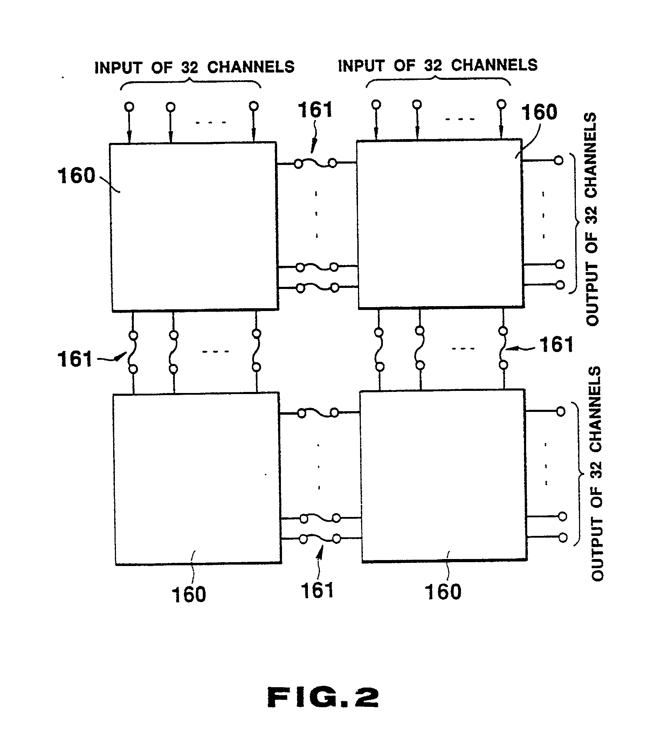

This matrix size ranges to an extent from 16 x 16 to 256 x 256. Hitherto, in order to cope with such various matrix sizes, there is adopted a system of cascade-connecting basic units (e.g., 16 x 16 or 32 x 32) to increase the scale of the matrix. Namely, this conventional cascade system uses both basic units for increasing the number of inputs and basic units for increasing the number of outputs to carry out cascade connection, thus to increase the number of input channels, the number of output channels, and the number of matrices of the cross points. Accordingly, in accordance with this cascade system in the case of attempting to use basic units 160 of, e.g., 32 x 32 to constitute a matrix switcher apparatus of 64 x 64 as shown in FIG. 2, four basic units 160 of 32 x 32 are used to implement cascade connections 161 to terminals of respective basic units 160. Thus, a matrix switcher apparatus of 64 x 64 is constituted.

However, in the case of attempting to constitute, e.g., a matrix switcher apparatus of 256 x 256 by the conventional cascade system as described above, 64 basic units of 32 x 32 must be used. For this reason, in such a large scale system, the size and the cost of the system in total are increased to much extent.

Further, since the conventional basic units of the matrix switcher apparatus only have a few kinds of sizes, e.g., 16 x 16, or 32 x 32, etc., it is difficult to desirably change the matrix scale. For example, it is difficult to constitute a matrix having a size smaller than that of the basic unit, or a size extremely larger than that of the basic unit.

It is an object of the present invention to provide a matrix switcher apparatus which permits the system for the matrix switcher apparatus to be compact, and permits it to be constituted on various scales, and which can reduce the cost.

The matrix switcher apparatus according to this invention is directed to a matrix switcher apparatus adapted to arbitrarily inputs of a plurality of channels to outputs of a plurality of channels to deliver the distributed outputs, characterized in that the matrix switcher apparatus is permitted to have therein a cross point matrix adapted for connecting one matrix switcher unit to any other matrix switcher unit or units to carry out expansion of input/output, and that input and output terminals expandable up to a predetermined maximum number of channels can be provided in the matrix switcher apparatus.

Further, the matrix switcher apparatus of this invention comprises a first cross point matrix including the input terminals of the plurality of channels, and output terminals of at least partial channels of the plurality of channels and channels expandable to any other matrix switcher unit or units; and a second cross point matrix including input terminals of the partial channels from the first cross point matrix and channels from any other matrix switcher unit or units, and output terminals of partial channels of the matrix switcher apparatus. Here, the first and second cross point matrices may be comprised of at least a single substrate.

In accordance with this invention, since the cross point matrix for expansion of input/output can be provided within the apparatus, and input/output terminals expandable up to a predetermined maximum number of channels can be provided therein, it is possible to enlarge the matrix size up to the maximum number of channels. Further, since the first and second cross point matrices can carry out input/output only by using partial channels, the matrix size can be reduced. Accordingly, the matrix switcher apparatus can be connected to other matrix switcher apparatuses by using the expansion channels. Thus, the matrix size can be also enlarged.

The invention will be further described by way of non-limitative example with reference to the accompanying drawings in which:

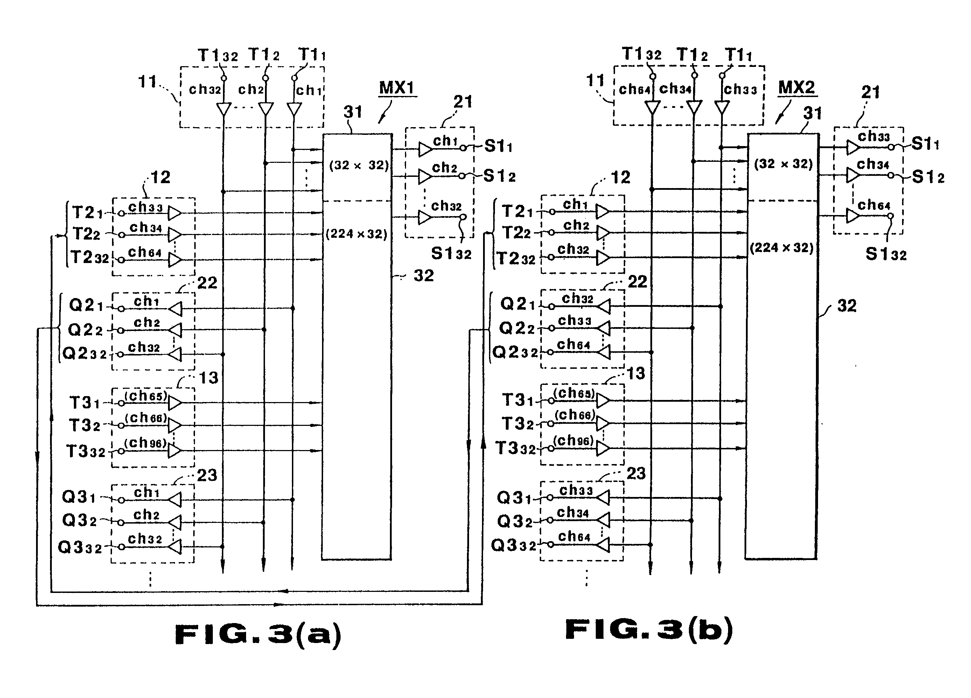

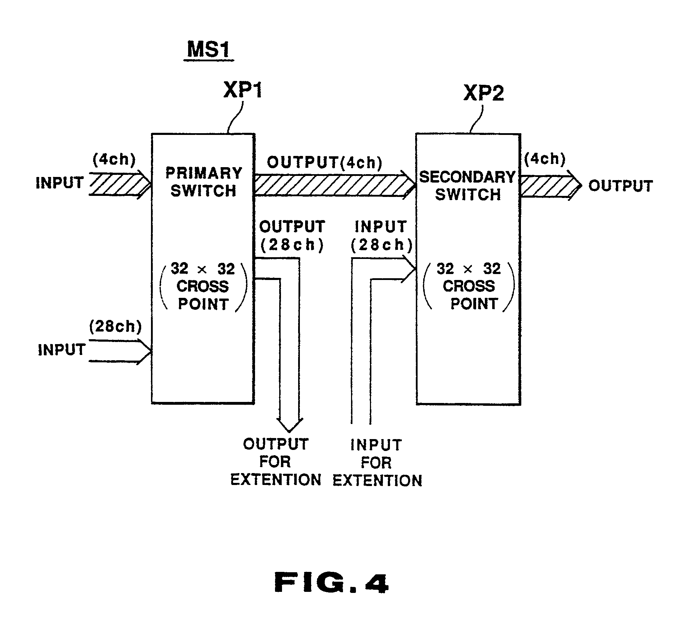

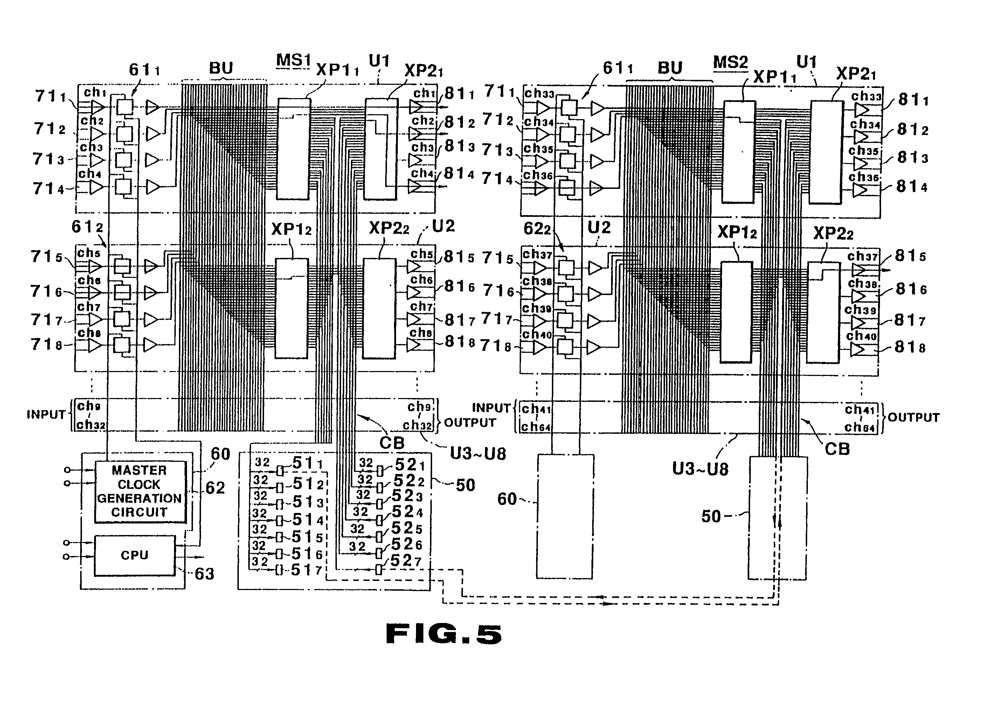

FIG. 1 is a block diagram for explaining how the matrix switcher apparatus is used, and FIG. 2 is a block diagram showing the connecting state in the case of realizing a matrix size of 64 x 64 by using a conventional matrix switcher apparatus, FIG. 3 is a circuit diagram showing, in a block form, the outline of the configuration of a matrix switcher apparatus according to a first embodiment of this invention, FIG. 4 is a block diagram showing the outline of the configuration of a matrix switcher apparatus according to a second embodiment of this invention, FIG. 5 is a circuit diagram showing, in a block form, an actual configuration of the second embodiment.

An embodiment to which this invention is applied will now be described with reference to the attached drawings.

FIG. 3(a) is a block diagram showing the outline of the configuration of a matrix switcher apparatus of a first embodiment of this invention. FIG. 3(b) also shows the apparatus of the first embodiment. The apparatus of the first embodiment shown in FIGS. 3(a) and (b) is directed to matrix switcher units or arrangements MX1 and MX2 for arbitrarily distributing inputs (e.g., video or audio signals of 32 channels, etc.) through input terminals $TI_1$ to $TI_{32}$ to outputs of a plurality of channels (32 channels) (output terminals $S1_1$ to $S1_{32}$) to deliver the distributed outputs. The cross point matrix 32 for connecting one matrix switcher unit MX2 to the other matrix switcher unit MX1 to carry out expansion of input/output can be provided in the matrix switcher units MX1 and MX2. Further, an arrangement is employed in which expandable output terminals $T2_1$ to $T2_{32}$, $T3_1$ to $T3_{32}$, ..., and expandable output terminals $Q2_1$ to $Q2_{32}$, $Q3_1$ to $Q3_{32}$, ... up to a predetermined maximum number of channels (e.g., 256 channels) can be provided in the matrix switcher units MX1 and MX2.

Namely, in the matrix switcher unit MX1 of FIG. 3(a), the cross point matrix 31 has a matrix size of 32 x 32, and the cross point matrix 32 has a matrix size of 224 x 32. Accordingly, in the matrix switcher unit MX1, the size of 256 x 32 is provided as a whole by the cross point matrix 31 and the cross point matrix 32 for expansion. Here, inputs of 32 channels ch 1 to ch 32 delivered to respective input terminals T1, to $T1_{32}$ of an input terminal group 11 are transmitted to the cross point matrix 31. This cross point matrix 31 arbitrarily distributes these respective inputs of 32 channels to output distributed outputs from respective output terminals $S1_1$ to $s1_{32}$ of an output terminal group 21. Further, inputs of 32 channels from the input terminal group 11 are outputted through the expandable output terminals $Q2_1$ to $Q2_{32}$, $Q3_1$ to $Q3_{32}$, ...,

$Q8_1$ ... $Q8_{32}$ (indications of terminals $Q4_1$, to $Q4_{32}$, ..., $Q8_1$ ... $Q8_{32}$ are omitted in the Figure) of 7 expandable output terminal groups 22, 23, ..., 28 (indications of terminal groups 24 to 28 are omitted). Namely, since 32 expandable output terminals are provided with respect to seven expandable output terminal groups, the number of output terminals is equal to 224 in total. Further, seven input terminal groups 12, 13, ... 18 (indications of terminal groups 14 to 18 are omitted) are connected to the expandable cross point matrix 32. Further, input terminals $T2_1$ to $T2_{32}$, $T3_1$ to $T3_{32}$, ..., $T8_1$ to $T8_{32}$ (indications of terminals $T4_1$ to $T4_{32}$, ... $T8_1$ to $T8_{32}$ are omitted) of 32 channels are arranged in these respective expandable input terminal groups. Accordingly, since 32 expandable input terminals are provided every 7 expandable input terminal groups, the total number of input terminals is equal to 224.

In the apparatus of the first embodiment, by connecting the terminals of these expandable input and output groups to the expandable input/output terminals of a matrix switcher apparatus of an alternative of this embodiment, expansion of the matrix size can be conducted. Namely, e.g., in the case of carrying out distribution to outputs of inputs by using only one apparatus of the first embodiment shown in FIG. 3(a), inputs of 32 channels delivered to the input terminal group 11 are distributed to the output terminal group 21 by using the cross point matrix 31 of the matrix size (32 x 32). At this time, by connecting the expandable input/output terminal groups of the matrix switcher apparatus of the alternative of this embodiment and the expandable input/output terminal groups to each other, a matrix size of 32 x 32 or more can be realized. For example, where the apparatus of this embodiment and a single matrix switcher apparatus of the alternative of this embodiment are connected to each other, a matrix size of 64 x 64 is provided. Further, where the apparatus of this embodiment and seven matrix switcher apparatuses of the alternative of this embodiment are connected to each other, a matrix size of 256 x 256 can be realized.

Explanation will now be given in connection with the case where one matrix switcher apparatus of an alternative of this embodiment is used to realize the matrix size of 64 x 64. The matrix switcher unit MX2 of FIG. 3(b) is the same as the matrix switcher unit MX1 of FIG. 3(a).

Inputs of respective channels of 1 ch to 32 ch are delivered to the input terminal group 11 of the matrix switcher apparatus MX1, and inputs of respective channels of 33 up to 64 channels are delivered to the input terminal group 11 of the matrix switcher apparatus MX2. Here, terminals of the expandable output terminal group 22 of the apparatus MX1 are connected to terminals of the expandable input terminal group 12 of the matrix switcher unit MX2, respectively. Further, terminals of the expandable input terminal group 12 of the matrix switcher apparatus MX1 are connected to terminals of the expandable output terminal group 22 of the matrix switcher unit MX2, respectively. Namely, signals of channels 1 ch to 32 ch delivered to the unit MX1 are transmitted to the expandable input terminal group 12 of the matrix switcher unit MX2 through the expandable output terminal group 22 of the unit MX1. Further, signals of channels 33 ch to 64 ch delivered to the matrix switcher unit MX2 are transmitted to the expandable input terminal group 12 of the matrix switcher unit MX1 through the expandable output terminal group 22 of the unit MX2. For this reason, for example, in the case of distributing signals of the channel ch 1 at the matrix switcher unit MX1 to output terminals $S1_{32}$ of the unit MX1 to provide distributed outputs, signals of the channel ch 1 delivered to the input terminal $T1_1$ of the matrix switcher unit MX1 are distributed to the output terminal $s1_{32}$ of the unit MX1 by the selection of a corresponding switch in the cross point matrix 31 of the unit MX1. Further, for example, in the case of distributing signals of the channel ch 64 at the matrix switcher unit MX2 to the output terminal $S1_1$ of the unit MX2 to provide the distributed output, signals of the channel ch 64 delivered to the input terminal $t1_{32}$ of the unit MX2 are distributed to the output terminal $S1_1$ of the unit MX2 by the selection of a corresponding switch in the cross point matrix 31 of the unit MX2. Further, for example, in the case of distributing signals of the channel ch 2 delivered at the matrix switcher unit MX1 to output terminals $SI_2$ of the matrix switcher unit MX2 to output distributed outputs, signals of the channel ch 2 delivered to the input terminal $T1_2$ of the matrix switcher unit MX1 are delivered to the cross point matrix 32 of the unit 32 through the output terminal $Q2_2$ of the expandable output terminal group 22 of the matrix switcher unit MX1, and through the input terminal $T2_2$ of the expandable input terminal group 12 of the matrix switcher unit MX2. When corresponding switches in the cross point matrices 32 and 31 of the unit MX2 are selected, the above-mentioned signals are distributed to the output terminal $S1_2$ of the unit MX2.

In the above-described case of FIG. 3, there is shown an example of connection of two matrix switcher units. For example, three matrix switcher units are connected to each other. At this time, a matrix size of 96 x 96 can be realized. In this case, inputs of respective channels of 65 ch up to 96 ch are delivered to the input terminal group 11 of the third matrix switcher unit MX3 (of which indication is omitted). The connection between these three matrix switcher units MX1, MX2 and MX3 is as follows. Namely, the connection between the expandable output terminal groups 12 and 22 of the matrix switcher units MX1 and MX2 is the same as that in the case shown in FIG. 3. Here, the expandable input terminal group 13 of the matrix switcher unit MX1 is connected to each of the input terminal groups of the expandable output terminal

nal group 23 of the matrix switcher unit MX3, and the expandable output terminal group 23 of the matrix switcher unit MX1 is connected to the expandable input terminal group 13 of the unit MX3. Further, the expandable input terminal group 13 of the matrix switcher apparatus MX2 is connected to the expandable output terminal group 22 of the matrix switcher unit MX3. In addition, the expandable output terminal group 23 of the matrix switcher unit MX2 is connected to the expandable input terminal group 12 of the unit MX3.

In the case of making connections as described above between three matrix switcher units to distribute, e.g., signals of the channel ch 32 delivered at the matrix switcher unit MX1 to the output terminal $s1_1$ of the third matrix switcher unit MX3 of this embodiment to provide the distributed outputs, signals of the channel 32 delivered to the input terminal $T1_{32}$ of the matrix switcher unit MX1 are transmitted to the cross point matrix 32 of the unit MX3 through the output terminal $Q3_{32}$ of the expandable output terminal group 23 of the matrix switcher unit MX1, and through the input terminal $T2_{32}$ of the expandable input terminal group 13 of the matrix switcher unit MX3. When corresponding switches in the cross point matrices 32 and 31 of the unit MX3 are selected, the above-mentioned signals are distributed to the output terminal $s1_1$ of the unit MX3.

Meanwhile, in the previously described conventional matrix switcher apparatus, basic units having a matrix size of 16 x 16 or 32 x 32 are ordinarily accommodated within a standardized casing, such as, for example, so called EIA (Electronic Industries Association) unit, etc. All other components, e.g., power supply and/or controller (CPU), etc. for the switch of the apparatus are provided within the casing (every basic nits). For this reason, in order to realize a matrix size of, e.g., 256 x 256 by using this conventional apparatus, as previously described, 64 basic units are required, and 64 casings are also required as a whole. As a result, the system necessarily becomes large. Since casings and power supplies, etc. are required for the all, the cost is increased. On the contrary, in the matrix switcher unit of this embodiment, one matrix switcher unit has a matrix size of 256 x 32, and the above-mentioned power supply, and controller, etc. are arranged in this unit having the size of 256 x 32. In the case where the unit of EIA is used, the size of the casing for the apparatus of this embodiment can be held down to substantially two times larger than that of the conventional casing. For this reason, even in the case of seven units necessary for realizing a matrix size of 256 x 256, the size of the entirety of the system for the matrix switcher apparatus of this embodiment can be reduced to that of about (7 x 2)/64 in the case of realizing the matrix size of 256 x 256 with the conventional apparatus. Further, since it is sufficient to use casings and/or power supplies, etc. corresponding to seven units, the cost can be held to a low value.

For the above-described reasons, in the apparatus of the first embodiment, by connecting seven matrix switcher units at the maximum, matrix size of 256 x 256 can be realized. Even in this case, the scale of the system can be smaller than that of the conventional apparatus, and the cost can be reduced to more degree.

FIG. 4 is a block diagram showing the outline of the configuration of a matrix switcher apparatus according to a second embodiment of this invention. The matrix switcher unit MS1 of the second embodiment shown in FIG. 4 comprises a primary switch XP1 serving as a first cross point matrix including the input terminals of a plurality of channels (e.g., 32 channels), and output terminals of at least partial channels (e.g., 4 channels) of the plurality of channels and expandable channels (28 channels) to the other matrix switcher unit MS2 (which is the same configuration as that of the matrix switcher unit MS1 and its indication is omitted), and a secondary switch XP2 serving as a second cross point matrix including input terminals of the partial channels (4 channels) from the primary switch XP1 and expandable channels (28 channels) from the other matrix switcher unit MS2, and output terminals of partial-channels (4 channels) of the matrix switcher unit MS1. Here, the above-mentioned primary and secondary switches XP1 and XP2 can be constructed at least on a single substrate.

Namely, in FIG. 4, there is employed an arrangement in which eight substrates on which the primary and secondary switches $XP_1$ and $XP_2$ are arranged are used to arbitrarily distribute inputs of 32 channels to provide the distributed outputs. The switches XP1 and XP2 are arranged on a single substrate of the matrix switcher unit MS1 have both, e.g., a matrix size of 32 x 32. Here, signals of four channels 1 ch to 4 ch are delivered to four input terminals of 32 input terminals of the primary switch XP1. Further, signals of 4 channels from other respective seven substrates (28 channels ch 5 to ch 32 in total) are delivered to the remaining 28 input terminals. At this time, the primary switch XP1 has a function to make a selection up to 4 channels from these input 32 channels by the switch selection to output selected ones. The 4 channel outputs at the primary switch XP1 are transmitted to the secondary switch XP2. Further, the remaining 28 channels of the primary switch XP1 are connected to output terminals (expandable output terminals corresponding to 28 channels) to the other matrix switcher unit MS2, respectively. In addition, four channel outputs from the primary switch XP1 are delivered to the secondary switch XP2, and 28 channel outputs from the expandable output terminals of the other matrix switcher unit MS2 are delivered to the secondary switch XP2 through expandable output terminals. Namely, this secondary switch XP2 has a function to make a selection up to arbitrary 4 channels, by switch selection, from 32 channels in total of 4 channel inputs from the primary switch XP1 and 28 channel inputs from the other matrix switcher apparatus MS2 to output them. The matrix size of 32 x 32 is realized by such eight substrates.

FIG. 5 shows an actual configuration of the above-described matrix switcher apparatus of the second embodiment, and an example in which matrix size of 64 x 64 is realized by connection of two matrix switcher units.

In the matrix switcher apparatus MS1 of FIG. 5, the above-described eight substrates are used to realize a matrix size of 32 x 32. Further, the matrix switcher unit MS1 and the matrix switcher unit MS2 of the same structure as MS1 are connected to realize the matrix size of 64 x 64.

Namely, in FIG. 5, the primary switches $XP1_1$, to $XP1_8$ of substrates U1 to U8 (indications of actual configurations of U3 to U8 are omitted) of the matrix switcher apparatus MS1 can provide inputs of 32 channels of inputs of respective 4 channels through input terminals $71_1$ to $71_{32}$ (terminal $71_9$ and terminals succeeding thereto are omitted) and inputs every respective 4 channels (28 channels in total) from the other seven substrates through the bus BU for interface in the unit to select and output 4 channels of these channels, respectively. Here, the above-mentioned four channel inputs to the respective primary switches XP1 to $XP1_8$ are delivered through buffer circuits $61_1$ to $61_8$ (indications of circuit $61_3$ and circuits succeeding thereto are omitted) each comprised of an amplifier, or a latch circuit, etc. Further, outputs from the control circuit 60 comprised of a master clock generation circuit 62 and a CPU 63 are delivered to the latch circuits $61_1$ to $61_8$, respectively. From the CPU 63, a control signal for switch selection at the primary and secondary switches are also outputted. Further, outputs of the remaining 28 channels of the respective primary switches $XP1_1$ to $XP1_8$ are transmitted to one expandable input terminal group of the expandable input/output terminal section 50 of the other matrix switcher unit MS2 from a certain expandable output terminal group of expandable output terminal groups $51_1$ to $51_7$ of the expandable input/output section 50 through the bus CB for expandable interface. Here, seven expandable output terminal groups $51_1$ to $51_7$ of the expandable input/output terminal section 50 are each comprised of terminals corresponding to 32 channels, and can be connected to the matrix switcher unit of the alternative of this embodiment every respective output terminal groups. Accordingly, matrix size of 256 x 256 can be realized at the maximum by 32 channels at the matrix switcher MS1 and 224 channels in total at the other matrix switcher unit connected to the seven expandable output terminal groups $51_1$ to $51_7$. Further, to secondary switches $XP2_1$ to $XP2_8$ (indications of switch $XP2_3$ and

switches succeeding thereto are omitted), respective 4 channel outputs from the primary switches $XP1_1$ to $XP1_8$ are delivered, and respective 28 channel outputs from the expandable output terminal group of the expandable input/output terminal section 50 of the other matrix switcher unit MS2. At the secondary switches $XP2_1$ to $XP2_8$, arbitrary channels up to 4 channels are taken out, by switch selection, through output terminals $81_1$ to $81_{32}$ (indications of terminal $81_9$ and terminal succeeding thereto are omitted), from 32 channels of 4 channels plus 28 channels delivered thereto, respectively.

Here, for example, in the case where signals of the channel ch 1 delivered to the input terminal $71_1$ of the substrate $U_1$ at the matrix switcher unit MS1 are outputted to the output terminal $81_1$ of the unit MS1, signals of the channel ch 1 through respective elements of the buffer circuit $61_1$ are transmitted to the primary switch $XP1_1$. After switch selection is carried out at the primary switch $XP1_1$ (respective primary switches of the other substrates are all placed in OFF state), the above-mentioned signals are transmitted to the secondary switch $XP2_1$. At this switch, switch selection is carried out in the same manner as stated above and such signals are then outputted from the output terminal $81_1$. Further, for example, in the case where signals of the channel ch 5 delivered to the input terminal $71_5$ of the substrate U2 at the matrix switcher unit MS1 are outputted to the output terminal $81_4$ of the substrate U1 of the unit MS1, the signals of the channel ch 5 are transmitted to the secondary switch $XP2_1$ of the substrate U1 as the result of the fact that switch selection is carried out at the primary switch $XP_1$ of the substrate U1 (primary switches of other substrates are all placed in OFF state). Also at the secondary switch $XP2_1$, switch selective processing is carried out. The signals thus processed are outputted from the output terminal $81_4$. Further, for example, in the case where signals of the channel ch 6 delivered to the input terminal $71_6$ of the substrate U2 at the matrix switcher unit MS1 are outputted to the output terminal $81_5$ of the substrate U2 of the other matrix switcher unit MS2, signals of the channel ch 6 are transmitted to the secondary switch $XP2_2$ of the substrate U2 of the unit MS2 through the expandable output terminal group $51_1$ of the expandable input/output terminal section 50, and through a corresponding expandable input terminal group of the expandable output terminal section 50 of the other matrix switcher unit MS2 as the result of the fact that switch selection at the primary switch $XP1_2$ of the substrate U2 is carried out (primary switches of other substrates are all placed in OFF state.) At the secondary switch $XP2_2$, switch selection is carried out, and signals thus selected are outputted from the output terminal $81_5$. Further, for example, in the case where signals of the channel ch 36 delivered to the input terminal $71_4$ of the substrate U1 of the other matrix switcher unit MX2 are outputted to the output terminal $81_2$ of the substrate U1 of the matrix switcher unit MS1, signals of the channel ch 36 are transmitted to the secondary switch $XP2_1$ of the substrate U1 of the unit MS1 through a corresponding expandable output terminal group of the expandable input/output terminal section 50, and through, e.g., a corresponding expandable input terminal $52_7$ of the expandable output terminal section 50 of the matrix switcher unit MS1 as the result of the fact that switch selection is carried out at the primary switch $XP1_1$ of the substrate U1 of the matrix switcher apparatus MS2 (primary switches of other substrates are all placed in OFF state). At the secondary switch $XP2_1$, switch selection is then carried out. Such signals thus selected are outputted from the output terminal $81_2$.

Namely, while, in the above-described matrix switcher apparatus of the second embodiment, eight substrates are used to realize a matrix size of 32 x 32, e.g., a single substrate may be only used to realize a small scale matrix switcher apparatus having a matrix size of 4 x 4. Further, by connecting a plurality of switcher units of the second embodiment, the matrix size can be expanded. For example, by connecting, to each other, only eight matrix switcher units of this embodiment, matrix size of 256 x 256 at the maximum can be provided. Since the matrix size of 256 x 256 at the maximum can be provided by eight units in this way, the cost can be reduced.

The matrix switcher apparatus of this invention is adapted so that it can have therein a cross point matrix for connecting one switcher unit to the other switcher unit to expand input/output, and that input/output terminals expandable up to a predetermined maximum number of channels can be provided in the apparatus. Accordingly, for example, even if the matrix size of 256 x 256 is employed, the scale of the entirety of the system can be compact, and the cost can be reduced. Further, the matrix switcher apparatus of this invention is adapted so that it comprises a cross point matrix including input terminals of a plurality of channels and output terminals of at least partial channels of the plurality of channels and channels expandable to other switcher units, and a cross point matrix including expandable input terminals from partial channels and other switcher units, and output terminals of partial channels of the apparatus. Accordingly, this apparatus can make alteration from a small matrix size, such as, for example, 4 x 4 to a large matrix size, such as, for example, 256 x 256. In addition, even if a matrix size of, e.g., 256 x 256 at the maximum is employed, the entirety of the system can be compact, and the cost can be reduced.

**Claims**

1. A matrix switcher apparatus adapted to arbitrarily distribute inputs of a plurality of channels to outputs of a plurality of channels to deliver the distributed outputs,

characterized in that said matrix switcher apparatus is permitted to have therein a cross point matrix adapted for connecting one matrix switcher unit to any other matrix switcher unit or units to carry out expansion of input/output, and

that input and output terminals expandable up to a predetermined maximum number of channels can be provided in said matrix switcher apparatus.

2. A matrix switcher apparatus according to claim 1,

characterized in that at least controller for controlling said cross point matrix and driving power supply are arranged in a casing of said matrix switcher apparatus.

3. A matrix switcher apparatus according to claim 1 or 2,

characterized in that a cross point matrix adapted for input/output and said cross point matrix adapted for expansion of input/output are arranged in a predetermined standardized casing of said matrix switcher apparatus.

4. A matrix switcher apparatus adapted to arbitrarily distribute inputs of a plurality of channels to outputs of a plurality of channels to deliver the distributed outputs,

said apparatus comprising;

a first cross point matrix including said input terminals of the plurality of channels, and output terminals of at least partial channels of said plurality of channels and channels expandable up to any other matrix switcher unit or units, and

a second cross point matrix including input terminals of said partial channels from said first cross point matrix, and expandable channels from any other matrix switcher unit or units, and output terminals of partial channels of said matrix switcher apparatus

5. A matrix switcher apparatus according to claim 4,

characterized in that said first and second cross point matrices are constructed at least on a single substrate.

6. A matrix switcher apparatus according to claim 4 or 5, which comprises control circuit for controlling said first and second cross point matrices.

**FIG.1**

**FIG.2**

FIG.3(a)   FIG.3(b)

EP 0 449 632 A2

## MS1

# FIG.4

**FIG.5**

EP 0 449 632 A2

13